Europäisches Patentamt

European Patent Office

Office européen des brevets

(11) Veröffentlichungsnummer: **0 233 618**
**A2**

(12) # EUROPÄISCHE PATENTANMELDUNG

(21) Anmeldenummer: **87102110.1**

(22) Anmeldetag: **14.02.87**

(51) Int. Cl.⁴: **H03M 1/30**

(30) Priorität: **19.02.86 DE 3605178**

(43) Veröffentlichungstag der Anmeldung:
**26.08.87 Patentblatt 87/35**

(84) Benannte Vertragsstaaten:
**DE ES FR GB IT SE**

(71) Anmelder: **Standard Elektrik Lorenz**
**Aktiengesellschaft**
**Lorenzstrasse 10**
**D-7000 Stuttgart 40(DE)**

(72) Erfinder: **Becker, Helmut, Dr.**
**Noriker Strasse 19**
**D-8500 Nürnberg(DE)**

(74) Vertreter: **Hösch, Günther, Dipl.-Ing. et al**
**c/o Standard Elektrik Lorenz AG Patent- und**
**Lizenzwesen Kurze Strasse 8 Postfach 30 09**
**29**
**D-7000 Stuttgart 30(DE)**

(54) **Bewegungssensor.**

(57) Ein Sensor mit wenigstens zwei im Streufeld eines Permanentmagneten angeordneten magnetfeldabhängigen Widerständen und einer zugeordneten elektronischen Auswerteschaltung zur Erfassung der Bewegung eines mit Zähnen versehenen Gegenstandes, wobei zumindest die Zähne aus ferromagnetischem Material bestehen, wird erfindungsgemäß dadurch verbessert, daß die zwei oder jeweils zwei oder mehr magnetfeldabhängige Widerstände (5; 6) in Form von Streifen auf einem Träger (4) hintereinander in Richtung der Zähne (2) bzw. der Zahnlücken (3) angeordnet sind, und daß die oder wenigstens eine Zahnlücke (3.1) auf der Seite (10) des einen magnetfeldabhängigen Widerstandes (6) durch ferromagnetisches Material (11) aufgefüllt oder ein Zahn (2.1; 2.11; 2.12) ausgelassen oder verkürzt ausgebildet ist, und daß dem Sensor (8) eine Auswerteschaltung zugeordnet ist, die bei Abtastung der ausgefüllten Zahnlücke (3.1) oder des ausgelassenen oder verkürzten Zahnes (2.1; 2.11; 2.12) ein Steuersignal (A; B) ausgibt. Hierdurch kann der Sensor in kompakter Weise und aus wenigen robusten Bauteilen hergestellt werden.

Fig.1

## Bewegungssensor

Die vorliegende Erfindung bezieht sich auf einen Sensor zur Erfassung der Bewegung eines gezahnten Gegenstandes gemäß dem Oberbegriff des Anspruchs 1.

Bei einem bekannten Sensor zur Erfassung der Drehbewegunb eines ferromagnetischen Zahnrades besteht dieser aus einer Spule mit Eisenkern, der mit seiner einen freien Stirnkante gegen die Zähne gerichtet ist.

Beim Vorbeibewegen der Zähne wird die Induktivität der Spule verändert. Diese Veränderung dient als Kriterium zur Auswertung in einer Auswerteschaltung.

Es sind auch Sensoren auf optoelektrischer Basis zur Feststellung der Drehzahl und Drehrichtung eines Rades bekannt, die mit zwei eventuell gegeneinander versetzten optoelektrischen Sende-Empfängern arbeiten.

Die Erfindung befaßt sich mit der Aufgabe der Bewegungs-, insbesondere Drehzahlerkennung, ggf. auch nach Geschwindigkeit und/oder Bewegungsrichtung mit einfachen robusten Bauteilen, die zu einem kompakten Sensor zusammenfaßbar sind und eine hohe Genauigkeit der Bewegungserkennung, insbesondere auch bei langsamen Bewegungsabläufen ermöglicht. Zugleich soll die Möglichkeit einer Bezugspunkterkennung gegeben sein.

Gelöst wird diese Aufgabe durch die im Kennzeichen des Anspruchs 1 angegebenen Merkmale. Die magnetfeldabhängigen Widerstände sind in den Abmessungen klein, sehr stabil gegen Schockbeanspruchung und sie sind kostengünstig herstellbar. Außerdem ist durch die einfache Maßnahme der Lückenausfüllung oder Zahnverkürzung bzw. Zahnentfernung eine einfache Positionserkennung möglich. Ein derart kompakter Aufbau durch Zusammenbau von zwei der eingangs genannten Induktivitäten als Sensoren ist wegen der möglichen gegenseitigen Verkopplung nicht tragbar.

Weitere vorteilhafte Einzelheiten der Erfindung sind in den Unteransprüchen angegeben und nachfolgend anhand der in der Zeichnung veranschaulichten Au$führungsbeispiele beschrieben. Dabei zeigen:

Figur 1 einen Abschnitt einer Zahnstange mit einem Positionserkennungsbereich in perspektivischer Ansicht,

Figur 2 den Abschnitt von oben in einem in geringem Abstand von der Oberfläche vorgenommenen Schnitt,

Figur 3 ein Prinzipschaltbild einer Auswerteschaltung zur Signalerkennung für einen oder mehrere je einer Seite zugeordneten magnetfeldabhängigen Widerstände,

Figur 4 eine Ausführung mit einem um eine halbe Zahnbreite versetzten magnetfeldabhängigen Widerstand, die

Figur 5, 6 und 7, 8 je eine den Figuren 1 und 2 entsprechende Darstellung einer Version mit fehlendem bzw. verkürzten Zahn,

Figur 9 ein Prinzipschaltbild einer Auswerteschaltung für Vor-Rück-Erkennung und Impulszählung,

Figur 10 ein Prinzipschaltbild zur Nullpunkterkennung bei phasengleichen Signalen und

Figur 11 ein Prinzipschaltbild der NuLlpunkterkennung bei phasenversetzten Signalen.

Mit 1 ist ein mit Zähnen 2 und Zahnlücken 3 versehener bewegbarer Gegenstand bezeichnet. Dieser besteht ganz oder zumindest im Bereich der Zähne 2 aus ferromagnetischem Material. Anstelle von Zähnen 2 und Zahnlücken 3 können auch unterschiedliche permanentmagnetische Bereiche vorgesehen sein, beispielsweise in bestimmten Abständen vorgesehene Nord-oder Süd-oder Nord- und Südpole. Der Gegenstand 1 kann als Rad oder Stange oder in anderer Kurvenform ausgebildet sein. Die Zähne 2 und Zahnlücken 3 können wie dargestellt auf der Umfangsfläche oder aber seitlich oder zusätzlich seitlich angeordnet sein.

In geringem Abstand oberhalb der Zähne 2 ist ein Substrat 4 aus elektrisch isolierendem Material mit zwei als Streifen ausgebildeten, in Streifenrichtung hintereinander im Abstand voneinander angeordneten magnetfeldabhängigen Widerständen 5 und 6 vorgesehen. Die magnetfeldabhängigen Widerstände 5, 6 bestehen vorzugsweise aus einer in Form von Streifen aufgebrachten, z.B. aufgedampften oder aufgesputterten Schicht aus NiFe oder CoFeB oder FeB und einer Dicke von maximal $0{,}5\mu m$. Während oder nach dem Beschichtungsprozeß der Streifen wird diese Schicht einem derartigen Magnetfeld ausgesetzt, daß sie eine einachsigeAnisotropie mit der leichten Richtung parallel zu den Streifen aufweisen. Dadurch ist gewährleistet, daß jede unterschiedliche Magnetfeldkomponente H, d.h. jede Änderung, die senkrecht zur Streifenlängsachse L auftritt, eine Änderung des Wertes des magnetfeldabhängigen Widerstandes bzw. der magnetfeldabhängigen Widerstände im gleichen Sinn bewirkt. Zweckmäßig können jeweils bis zu vier Streifen vorgesehen und zu einer Brückenschaltung zusammengeschaltet sein.

Das Magnetfeld H wird beispielsweise durch ein Streufeld eines Permanentmagneten 7 erzeugt, dessen einer Pol über den magnetfeldabhängigen Widerständen 5, 6 vorgesehen ist.

Die magnetfeldabhängigen Widerstände 5, 6 und der Magnet 7 sowie Anschlüsse sind in einem nicht dargestellten Gehäuse untergebracht und bilden einen kompakten kleinen Sensor 8.

Die streifenförmigen magnetfeldabhängigen Widerstände 5, 6 erstrecken sich in Richtung der Zähne 2 bzw. der Zahnlücken 3 und sie sind wesentlich schmaler als diese. Dadurch wird an jeder Zahnflanke eine Widerstandsänderung derselben erzeugt.

Die Länge der magnetfeldabhängigen Widerstände 5, 6 und die Breite B der Zähne 2 ist so bemessen, daß je ein magnetfeldabhängiger Widerstand 5 oder 6 eine Seite 9 bzw. 10 der Zahnbreite B abtasten kann. Anstelle eines einzigen magnetfeldabhängigen Widerstandes 5 oder 6 können jeweils mehrere parallel zueinander vorgesehen und in Brückenschaltung zusammengeschaltet sein.

Auf der Seite 10 ist erfindungsgemäß zur Positionserkennung eine Zahnlücke 3.1 durch einen ferromagnetischen Teil 11 ausgefüllt. Beim Vorbeibewegen dieses Teils 11 entsteht daher im magnetfeldabhängigen Widerstand 6 keine Widerstandsänderung, wohl aber im magnetfeldabhängigen Widerstand 5, da für diesen die Zahnlücke 3.1 erhalten bleibt. In einer Auswerteschaltung kann daher die Vorbeibewegung dieser Stelle bzw. des Teils 11 festgestellt werden.

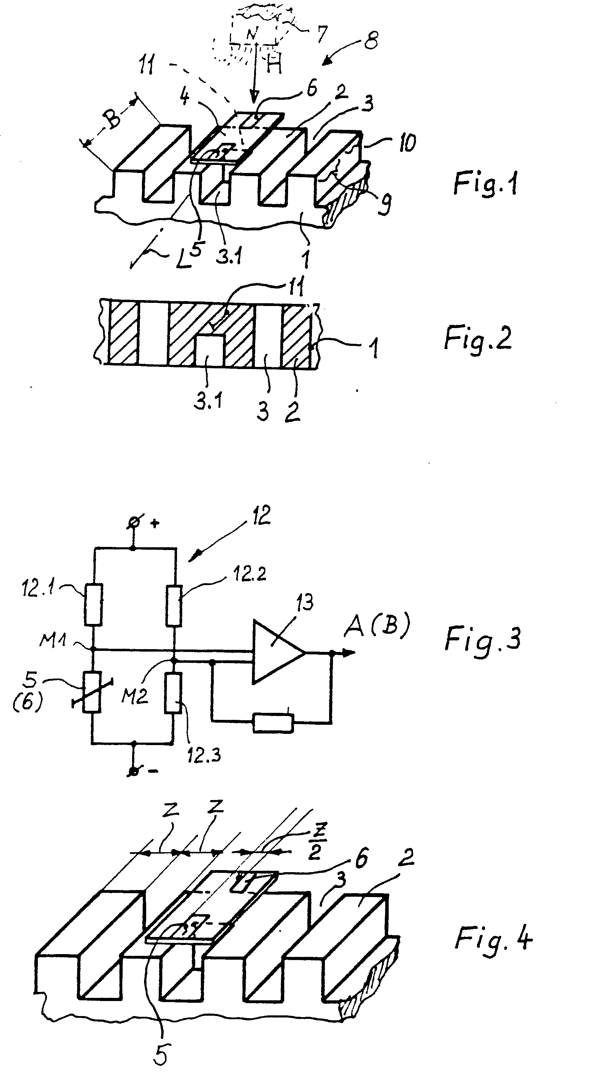

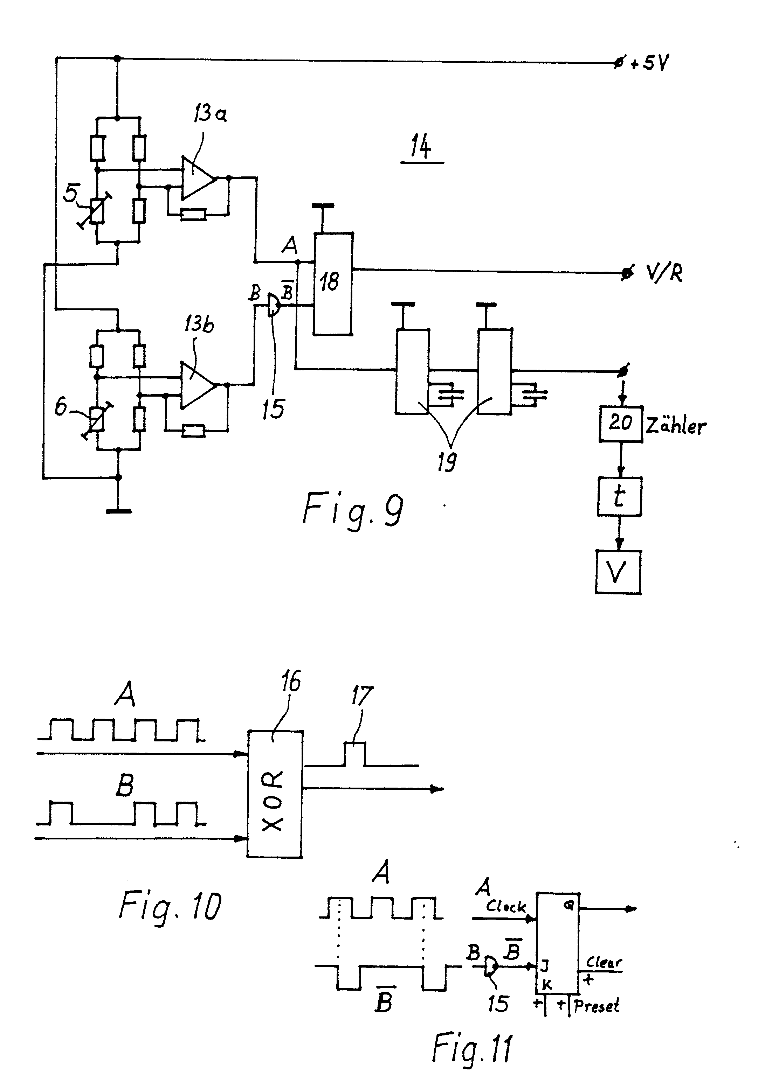

Eine Schaltung zur Erzeugung eines Impulses bei negativer Flanke ist im Prinzip in Figur 3 dargestellt. Der magnetfeldabhängige Widerstand 5 - (oder 6) liegt in einem Brückenkreis einer Meßbrücke 12 mit den Brückenwiderständen 12.1, 12.2, 12.3. Die Brückenpunkte M1, M2 sind an die beiden Eingänge eines Komparators 13 angeschlossen. Bei jeder negativen Flanke des durch den magnetfeldabhängigen Widerstand 5 erzeugten Signals gibt der Komparator 13 beispielsweise ein positives Signal A, der magnetfeldabhängige Widerstand 6 ein positives Signal B aus, wie später noch anhand der Figur 9 beschrieben wird.

Mit einer derartigen Anordnung kann die Zahl der Zähne, die Geschwindigkeit der Bewegung derselben und damit des Gegenstandes 1 und die den magnetischen Teil 11 entsprechende Positionsmarke erkannt werden.

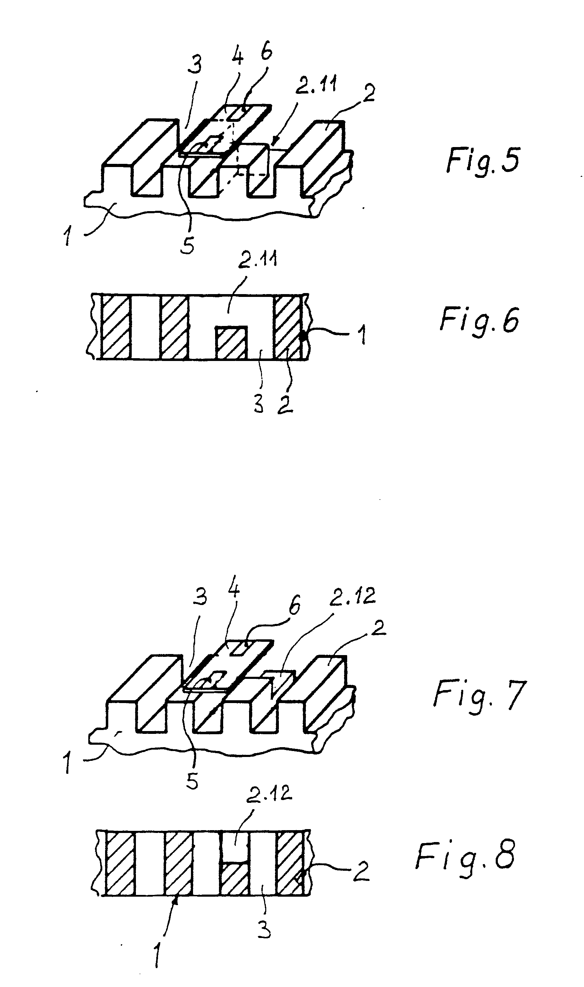

Um noch die Bewegungsrichtung, beispielsweise die Drehrichtung eines Rades, feststellen zu können, können gemäß Figur 5 die magnetfeldabhängigen Widerstände 5 und 6 gegeneinander versetzt, insbesondere um eine halbe Zahnbreite Z versetzt, die Signalkurve also um 90° phasenverschoben sein. Diese Anordnung wird später als VorRück-Schaltung beschrieben.

Anstelle eines magnetischen Teils 11 kann auch der Zahn 2.1 auf der Seite 10 des bzw. der magnetfeldabhängign Widerstände 6 zum Teil oder ganz abgetragen sein, so daß auch dadurch eine Positionserkennung infolge Ausbleibens eines Signals möglich ist. Die Ausführung ohne Zahn 2.11 ist in den Figuren 5 und 6, eine solche mit verkürztem Zahn 2.12 in den Figuren 7 und 8 dargestellt.

Die Funktion des Sensors 8 mit einer Auswerteschaltung 14, einer Vor-Rück-Erkennung und einer Positionserkennung ist in Figur 9 als Prinzipschaltbild dargestellt. Wie bereits erwähnt, ist jeder magnetfeldabhängige Widerstand 5 bzw. 6 je einer Seite 9 bzw. 10 an einem Komparator 13a bzw. 13b angeschlossen, die ein entsprechendes Pulsdiagramm A bzw. B ausgeben, wie in Figur 10 für nicht versetzte bzw. in Figur 11 für versetzte magnetfeldabhängige Widerstände 5, 6 dargestellt ist. Für den letzteren Fall ist das Signal B durch einen Inverter 15 invertiert.

Wie in Figur 10 veranschaulicht, können die beiden Signale A und B den beiden Eingängen eines XOR-Bausteins 16 eingegeben werden. Dieser gibt nur im Fall des Fehlens eines Impulses infolge Auftretens des magnetischen Teils 11 bzw. des Fehlens eines Zahnes 2.1 einen Impuls 17 aus. Dieser dient dann als Positionsmarke des beweglichen Gegenstandes 1.

Bei zusätzlicher Versetzung der magnetfeldabhängigen Widerstände 5 und 6 um z.B. eine halbe Zahnbreite Z wird das Signal A und das invertierte Signal $\overline{B}$ einem JK-Flipflop 18 eingegeben, der je nach Bewegungsrichtung des beweglichen Gegenstandes 1 am Ausgang ein H-oder L-Signal liefert.

Die Impulse des magnetfeldabhängigen Widerstandes 5, die alle pro Längeneinheit oder Umdrehung eines Rades vollständig vorhanden sind, können direkt oder über eine Verzögerungsschaltung 19 einem Zähler 20 zugeleitet werden, dem noch eine Schaltung zur Messung der Zeit t und der Geschwindigkeit V nachgeschaltet sein können.

**Ansprüche**

1. Sensor mit wenigstens zwei im Streufeld eines Permanentmagneten angeordneten magnetfeldabhängigen Widerständen und einer zugeordneten elektronischen Auswerteschaltung, zur Erfassung der Bewegung eines mit Zähnen versehenen Gegenstandes, wobei zumindest die Zähne aus ferromagnetischem Material bestehen, **dadurch gekennzeichnet,** daß die zwei oder jeweils zwei oder mehr magnetfeldabhängige Widerstände (5; 6) in Form von Streifen auf einem Träger (4) und hintereinander in Richtung der Zähne (2) bzw. der Zahnlücken (3) angeordnet sind, und daß die oder wenigstens eine Zahnlücke (3.1) auf der Seite (10) des einen magnetfeldabhängigen Widerstandes - (6) durch ferromagnetisches Material (11) ausgefüllt oder ein Zahn (2.1; 2.11; 2.12) ausgelassen oder verkürzt ausgebildet ist, und daß dem Sensor (8) eine Auswerteschaltung zugeordnet ist, die bei Abtastung der ausgefüllten Zahnlücke (3.1) oder des ausgelassenen oder verkürzten Zahnes (2.1; 2.11; 2.12) ein Steuersignal (A; B) ausgibt.

2. Sensor nach Anspruch 1, dadurch gekennzeichnet, daß die zwei hintereinander angeordneten magnetfeldabhängigen Widerstände (5, 6) seitlich gegeneinander versetzt angeordnet sind.

3. Sensor nach Anspruch 2, dadurch gekennzeichnet, daß die beiden magnetfeldabhängigen Widerstände (5, 6) um eine halbe Zahnteilung (Z) gegeneinander versetzt angeordnet sind.

4. Sensor nach Anspruch 1, 2 oder 3, dadurch gekennzeichnet, daß wenigstens ein magnetfeldabhängiger Widerstand (5; 6) als Brückenwiderstand im einen Zweig einer Meßbrücke (12) eingeschaltet ist und jeder Brückenmeßpunkt (M1, M2) an je einem Eingang eines Komparators (13) angeschlossen ist, dessen Ausgang in Abhängigkeit von gleichem und ungleichem Widerstandswert des magnetfeldabhängigen Widerstandes (5; 6) ein entsprechend unterschiedliches Ausgangssignal (A; B) ausgibt.

5. Sensor nach einem der Ansprüche 1 bis 4, dadurch gekennzeichnet, daß je ein magnetfeldabhängiger Widerstand (5 oder 6) und ein Meßwiderstand (12.1) je einen Brückenzweig bilden.

6. Sensor nach einem der Ansprüche 1 bis 5, dadurch gekennzeichnet, daß die Zähne (2) auf einem Rad angeordnet sind.

7. Sensor nach einem der Ansprüche 1 bis 5, dadurch gekennzeichnet, daß die Zähne (2) auf einer Stange angeordnet sind.

8. Sensor nach einem der Ansprüche 1 bis 7, dadurch gekennzeichnet, daß die Auswerteschaltung einen Impulszähler enthält.

9. Sensor nach einem der Ansprüche 1 bis 8, dadurch gekennzeichnet, daß der Sensor (8) und die Auswerteschaltung (14) in einem gemeinsamen Gehäuse untergebracht sind.

Fig.1

Fig.2

Fig.3

Fig.4

Fig.5

Fig.6

Fig. 7

Fig.8

Fig. 9

Fig. 10

Fig. 11